(19) Europäisches Patentamt
European Patent Office
Office européen des brevets

(11) EP 3 258 509 A1

(12) EUROPEAN PATENT APPLICATION

(43) Date of publication:
**20.12.2017 Bulletin 2017/51**

(51) Int Cl.:
***H01L 51/00*** *(2006.01)* ***H01L 51/05*** *(2006.01)*

(21) Application number: **16174445.3**

(22) Date of filing: **14.06.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Solvay SA**
**1120 Bruxelles (BE)**

(72) Inventors:
- **FENOLL, Mathieu**
**3078 Everberg (BE)**
- **VAN BEVEREN, Maxime**
**6032 Mont-Sur-Marchienne (BE)**

# (54) 9,9-DISUBSTITUTED 9,10-DIHYDROACRIDINE COMPOUNDS AND THEIR USE FOR DOPING CRYSTALLINE ORGANIC SEMICONDUCTORS

(57) The present invention concerns a composition comprising at least one crystalline organic semiconductor and at least one compound of formula

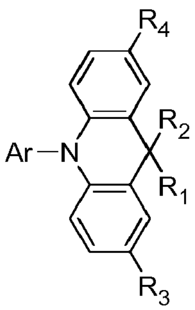

wherein $R_1$ and $R_2$ represent a $C_1$-$C_{50}$ hydrocarbyl or heterohydrocarbyl group, and wherein $R_3$ and $R_4$ represent H or a $C_1$-$C_{24}$ hydrocarbyl or heterohydrocarbyl group, and wherein Ar is an aryl or heteroaryl group.

EP 3 258 509 A1

## Description

The present invention concerns an organic semiconductor composition comprising an organic crystalline semiconductor and at least one compound bearing at least one optionally substituted 9,9-disubstituted-9,10-dihydroacridine moiety and the use thereof for the manufacture of organic semiconducting layers suitable for the manufacture of organic electronic devices.

Organic semiconducting layers have been the object of many attentions in the field of organic electronics. Especially when low cost organic electronics devices are targeted, one needs cheap material, easy processes and high cadences to produce the devices. Process to manufacture organic semiconducting thin layers may involve deposition under vacuum or may involve a solution process like ink printing. Liquid coating of organic semiconductor (OSC) composition is generally preferred over vacuum deposition techniques. The use of crystalline semiconductor such as TIPS-pentacene alone in a semiconducting layer may require drastic conditions and long times to promote convenient crystallization both being detrimental to manufacture with high cadences. Moreover, crystallization of any crystalline OSC alone is such a sensitive process that reproducibility may be impaired by minor changes during manufacturing.

DE102010061978 and J. Appl. Phys. 100, 023716 (2006) disclose the use of acridine orange base (AOB) as dopant for n-type organic semiconductors (n-type OSC) such as fluorocarbon-substituted dicyanoperylene-3,4:9,10-bis(dicarboximide) (PDIF-$CN_2$) and $C_{60}$ in a semiconducting layer of an organic field effect transistor (OFET). For this purpose, in order to be able to provide electron doping, AOB has a HOMO level which is higher than the LUMO level of n-type OSC. Field effect mobility measured for a device prepared in the presence of a small amount of dopant is generally higher than the mobility measured for a device prepared without dopant. However, with too high doping ratios the crystalline order of the semiconductor is disturbed and properties are reduced.

US2009165848 relates to organic electronic devices, which may be OFET, using quinacridine derivatives. In this patent application, quinacridine derivatives are used as crystalline OSC for OFET application and resulting devices have low performances. Moreover, the crystalline OSC is used alone in the semiconducting layer of the OFET, which may impair the stability and the reproducibility because of crystallization processes highly sensitive to experimental conditions.

There is a need for a new organic semiconductor composition suitable for preparing a semiconducting layer of an electronic device having reproducible properties, in particular reproducible high field effect mobility.

There is also a need for an organic semiconducting layer having high stability and, more particularly, bias stress stability.

There is also a need for an organic semiconductor composition suitable for preparing semiconducting layer having high field effect mobility, low cost and easy processing.

The needs previously described and others, are advantageously met by a composition comprising at least one crystalline organic semiconductor and at least one compound bearing at least one optionally substituted 9,9-disubstituted-9,10-dihydroacridine moiety, said compound corresponding to formula (a)

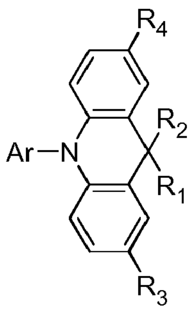

**Formula (a)**

and said compound being free of any spirobifluorene moiety corresponding to formula (b)

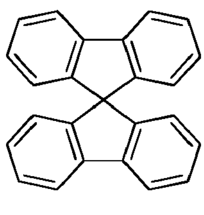

**Formula (b)**

wherein :

$R_1$ and $R_2$, which may be the same or different, represent a $C_1$-$C_{50}$ hydrocarbyl or heterohydrocarbyl group, optionally forming together an optionally substituted cyclic moiety,
$R_3$ and $R_4$, which may be the same or different, represent H or a $C_1$-$C_{24}$ hydrocarbyl or heterohydrocarbyl group, and
Ar is an optionally substituted aryl or heteroaryl group.

The term "hydrocarbyl" as used herein refers to a group only containing carbon and hydrogen atoms. The hydrocarbyl group may be saturated or unsaturated, linear, branched or cyclic. If the hydrocarbyl is cyclic, the cyclic group may be an aromatic or non-aromatic group.

The term "heterohydrocarbyl" as used herein refers to a hydrocarbyl group wherein one or more of the carbon atom(s) is/are replaced by a heteroatom, such as Si, S, N or O. Included within this definition are heteroaromatic rings, i.e. wherein one or more carbon atom within the ring structure of an aromatic ring is replaced by a heteroatom.

**Nature of Ar**

Ar is generally a substituted or unsubstituted aryl or a substituted or unsubstituted heteroaryl group, said aryl or heteroaryl group being derived from a compound selected from the list of compounds of following formulae:

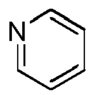
pyridine

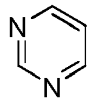
pyrimidine

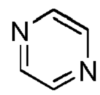
pyrazine

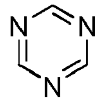
1,3,5-triazine

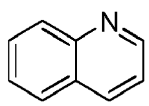
quinoline

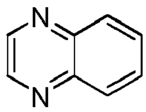
quinoxaline

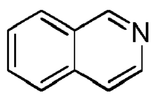
isoquinoline

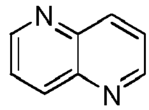
1,5-naphthyridine

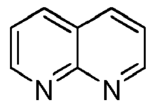
1,8-naphthyridine

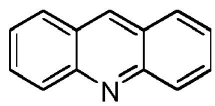
acridine

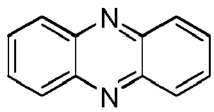
phenazine

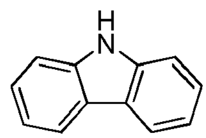
9*H*-carbazole

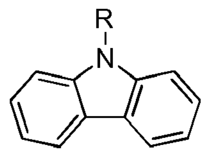
9-R-9*H*-carbazole

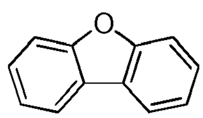
dibenzo[*b*,*d*]furan

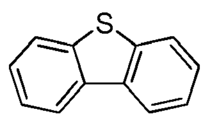
dibenzo[*b*,*d*]thiophene

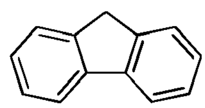
9*H*-fluorene

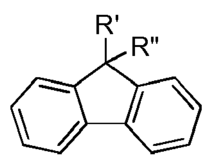
9-R'-9-R"-9H-fluorene

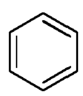
benzene

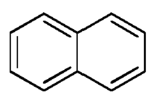
naphthalene

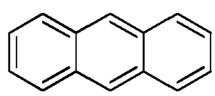
anthracene

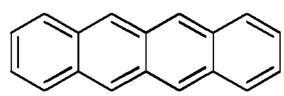
tetracene

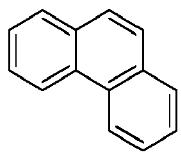

phenanthrene

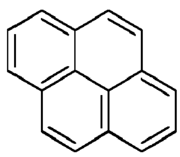

pyrene

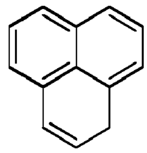

1*H*-phenalene

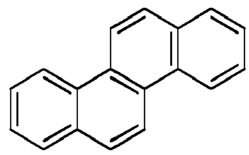

chrysene

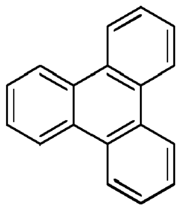

triphenylene

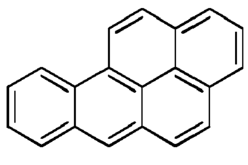

benzo[*pqr*]tetraphene

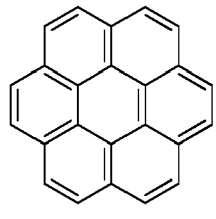

coronene

which compounds may be substituted or unsubstituted and, wherein R, R' and R" represent a $C_1$-$C_{24}$ hydrocarbyl or heterohydrocarbyl group.

By aryl or heteroaryl group derived from a compound comprising at least one aromatic or heteroaromatic ring, is meant an aryl or heteroaryl group that can be obtained by the removal of one hydrogen atom from the aromatic or heteroaromatic ring of the compound. For example, dibenzo[b,d]thiophen-2-yl can be obtained by removing the hydrogen atom in the position 2 of dibenzo[b,d]thiophene. Thus in the meaning of the present invention, dibenzothiophen-2-yl is an aryl group derived from dibenzothiophene.

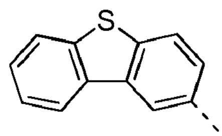

dibenzo[*b*,*d*]thiophen-2-yl

Ar may be substituted on any carbon atom by a substituent X, wherein X, which may be the same or different at each occurrence, represents H , -$NR_5R_6$, or a $C_1$-$C_{30}$ hydrocarbyl or heterohydrocarbyl group, wherein $R_5$ and $R_6$, which may be similar or different, are a phenyl group optionally substituted by a $C_1$-$C_{30}$ hydrocarbyl or heterohydrocarbyl group.

The said $C_1$-$C_{30}$ hydrocarbyl or heterohydrocarbyl group is preferably derived from an optionally substituted compound selected among the list comprising carbazole, dibenzothiophene, dibenzofuran and 9,9-disubstituted-9,10-dihydroacridine.

In a preferred embodiment, X is an optionally substituted 9,9-disubstituted-9,10-dihydroacridine corresponding to the formula (c)

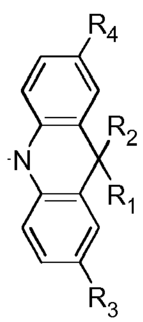

**Formula (c)**

wherein $R_1$, $R_2$, $R_3$ and $R_4$ are as previously defined.

Advantageously, Ar is a substituted or unsubstituted aryl or heteroaryl group, said group being derived from a compound selected from the list consisting of dibenzo[b,d]furan, dibenzo[b,d]thiophene, carbazole, fluorene, benzene,

naphthalene, anthracene and phenanthrene, which compounds may be substituted or unsubstituted.

Preferably, Ar is derived from dibenzo[b,d]thiophene, carbazole, fluorene or benzene, which compounds may be substituted or unsubstituted.

More preferably, Ar is derived from dibenzo[b,d]thiophene or benzene, which compounds may be substituted or unsubstituted.

Even more preferably, Ar is derived from substituted or unsubstituted dibenzo[b,d]thiophene.

**Nature of $R_1$ and $R_2$**

$R_1$ and $R_2$, which may be the same or different, are preferably selected among alkyl groups which may be linear, branched or cyclic and among optionally substituted phenyl groups. When substituted, phenyl groups are substituted with at least one substituent X as above defined.

More preferably, $R_1$ and $R_2$ are alkyl groups which may be linear, branched or cyclic.

Even more preferably $R_1$ and $R_2$ are methyl groups.

In a particular embodiment E*, $R_1$ and $R_2$ form together, an optionally substituted cyclic moiety. In embodiment E*, $R_1$ and $R_2$ form together an optionally substituted heterofluorenyl or fluorenyl moiety. In embodiment E*, more preferably, $R_1$ and $R_2$ form together an heterofluorenyl or a fluorenyl moiety which is substituted by at least one substituent X as previously described. In embodiment E*, still more preferably, $R_1$ and $R_2$ form together a fluorenyl moiety which is substituted by at least one substituent X as previously described. In embodiment E*, the most preferably, $R_1$ and $R_2$ form together a fluorenyl moiety which is substituted in position 3 and 6 by a substituent X as previously described; the case being the compound bearing at least one optionally substituted 9-$R_1$-9-$R_2$-9,10-dihydroacridine moiety according to the preferred embodiment E*, is represented in the formula (d) below

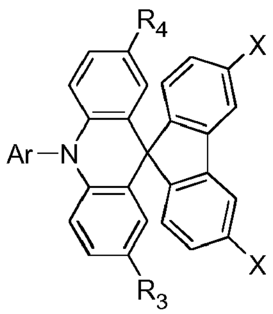

**Formula (d)**

wherein Ar, $R_3$, $R_4$ and X are as herein defined.

**Nature of $R_3$ and $R_4$**

Preferably, $R_3$ and $R_4$, independently from each other, are H or derived from a compound selected from the list of compounds comprising carbazole, dibenzothiophene, dibenzofuran and 9,9-disubstituted-9,10-dihydroacridine, which compounds may be substituted or unsubstituted with at least one substituent X as above defined.

More preferably, $R_3$ and $R_4$, independently from each other, are H or carbazole, which carbazole may be unsubstituted or unsubstituted with at least one substituent X as above defined.

Still more preferably, $R_3$ and $R_4$ are H or unsubstituted carbazole.

The most preferably, either $R_3$ and $R_4$ are H or $R_3$ and $R_4$ are unsubstituted carbazole.

**Embodiment E1**

In a preferred embodiment E1, Ar is derived from substituted or unsubstituted dibenzo[b,d]thiophene and is thus an optionally substituted dibenzo[b,d]thiophenyl group; it is preferably an optionally substituted dibenzo[b,d]thiophen-2-yl.

Ar is more preferably a dibenzo[b,d]thiophen-2-yl which is substituted with at least one substituent X as previously defined.

Ar is even more preferably a dibenzo[b,d]thiophen-2-yl which is substituted in position 8 with a substituent X as previously defined; the case being, a representation of the compound bearing at least one optionally substituted 9-$R_1$-9-$R_2$-9,10-dihydroacridine moiety according to the preferred embodiment E1 is provided by formula (e)

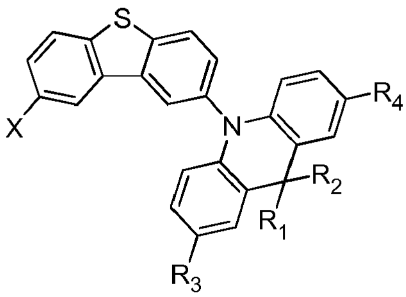

**Formula (e)**

wherein $R_1$, $R_2$, $R_3$, $R_4$ and X are as defined above.

In accordance with embodiment E1, X is advantageously an optionally substituted 9,9-disubstituted-9,10-dihydroacridine corresponding to the formula (c); the case being, a representation of the compound bearing at least one optionally substituted 9-$R_1$-9-$R_2$-9,10-dihydroacridine moiety according to the preferred embodiment E1 is provided by formula (f)

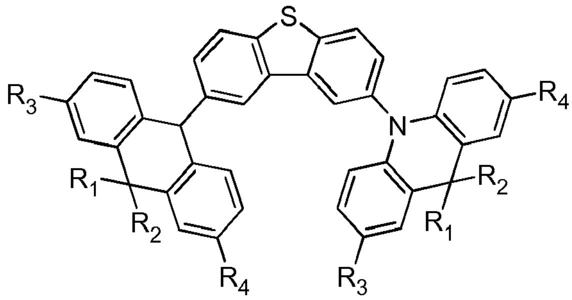

**Formula (f)**

wherein $R_1$, $R_2$, $R_3$ and $R_4$ are as defined above.

In accordance with embodiment E1, $R_1$ and $R_2$ are preferably methyl groups and $R_3$ and $R_4$ are preferably hydrogen atoms; the case being, a representation of the compound bearing at least one optionally substituted 9-$R_1$-9-$R_2$-9,10-dihydroacridine moiety according to the preferred embodiment E1 is provided by formula (g)

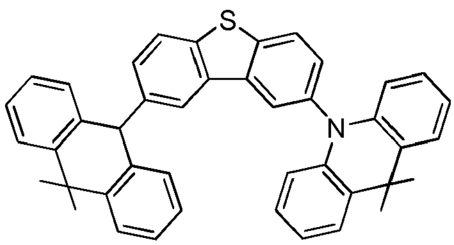

**Formula (g)**

**Embodiment E2**

In a preferred embodiment E2, Ar is derived from substituted or unsubstituted carbazole and is thus an optionally substituted carbazolyl group; it is preferably an optionally substituted carbazol-3-yl.
Ar is more preferably a carbazol-3-yl which is substituted with at least one substituent X as previously defined.

Ar is even more preferably a carbazol-3-yl which is substituted in position 6 with a substituent X as previously defined; the case being, a representation of the compound bearing at least one optionally substituted 9-$R_1$-9-$R_2$-9,10-dihydroacridine moiety according to the preferred embodiment E2 is provided by formula (h)

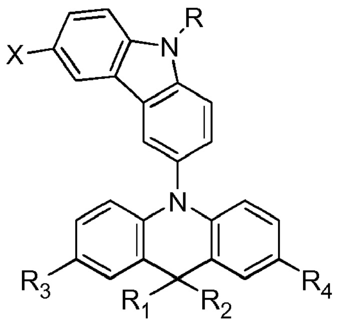

Formula (h)

wherein R, $R_1$, $R_2$, $R_3$, $R_4$ and X are as defined above.

**Embodiment E3**

In a preferred embodiment E3, Ar is derived from substituted or unsubstituted fluorene and is thus an optionally substituted fluorenyl group; it is preferably an optionally substituted fluorene-3-yl.

Ar is more preferably a fluorene-3-yl which is substituted with at least one substituent X as previously defined.

Ar is even more preferably a fluorene-3-yl which is substituted in position 6 with a substituent X as previously defined; the case being, a representation of the compound bearing at least one optionally substituted 9-$R_1$-9-$R_2$-9,10-dihydroacridine moiety according to the preferred embodiment E3 is provided by formula (i)

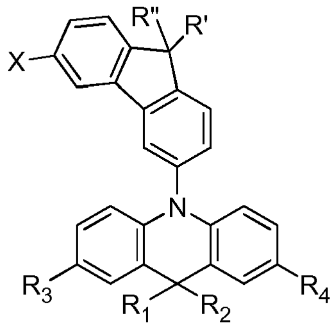

Formula (i)

wherein R', R", $R_1$, $R_2$, $R_3$, $R_4$ and X are as defined above.

**Embodiment E4**

In a preferred embodiment E4, Ar is derived from substituted or unsubstituted benzene group and is thus an optionally substituted benzyl group.

Ar is preferably a benzyl group which is substituted with at least one substituent X as previously defined.

Ar is more preferably an unsubstituted benzyl; the case being, a representation of the compound bearing at least one optionally substituted 9-$R_1$-9-$R_2$-9,10-dihydroacridine moiety according to the preferred embodiment E4 is provided by formula (j)

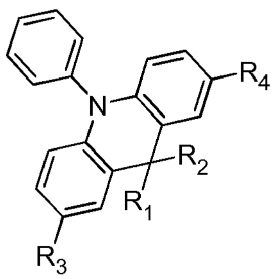

Formula (j)

wherein $R_1$, $R_2$, $R_3$ and $R_4$ are as defined above.

In accordance with embodiment E4, $R_1$ and $R_2$ are advantageously methyl groups and $R_3$ and $R_4$ are advantageously unsubstituted carbazole; the case being, a representation of the compound bearing at least one optionally substituted 9-$R_1$-9-$R_2$-9,10-dihydroacridine moiety according to the preferred embodiment E4 is provided by formula (k)

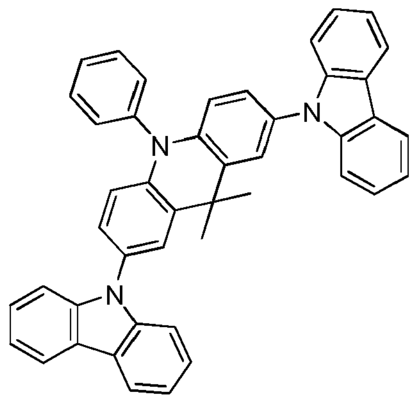

**Formula (k)**

**Binder**

In the composition according to the invention, the at least one compound bearing at least one optionally substituted 9-$R_1$-9-$R_2$-9,10-dihydroacridine moiety is advantageously used as binder.

Non exhaustive examples of compounds bearing at least one optionally substituted 9-$R_1$-9-$R_2$-9,10-dihydroacridine moiety particularly well suited to be used in the composition of the present invention are represented by formulae (I) to (XXV) below. Binders 1 to 2 represented below are even more particularly well suited to be used in the composition of the present invention.

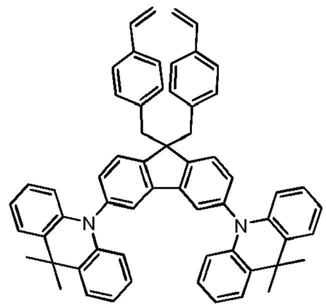

**(I)**

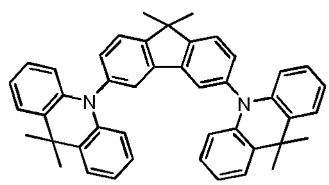

**(II)**

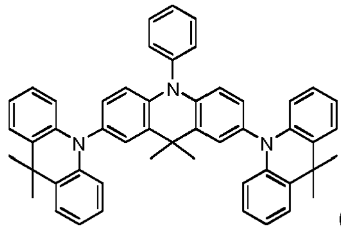

**(III)**

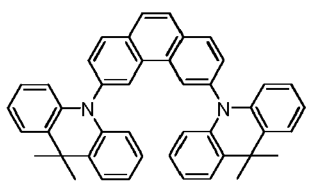

**(IV)**

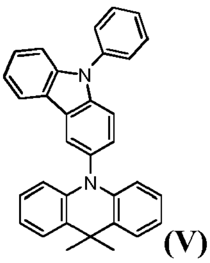 (V) 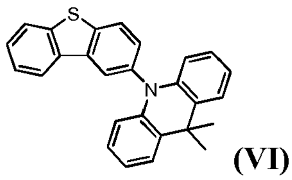 (VI)

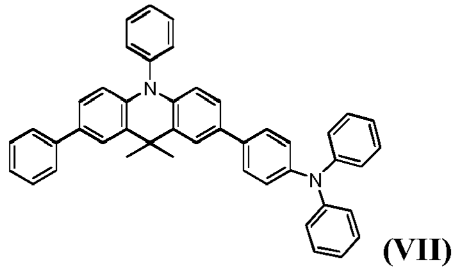 (VII) 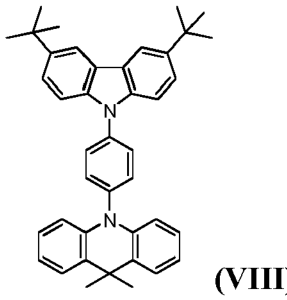 (VIII)

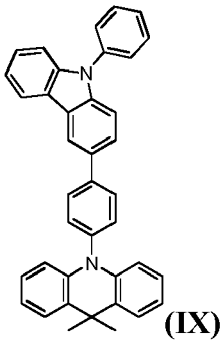 (IX) 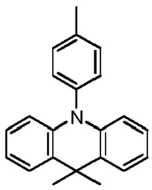 (X) 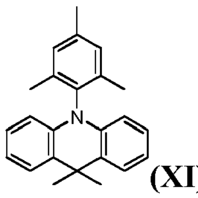 (XI)

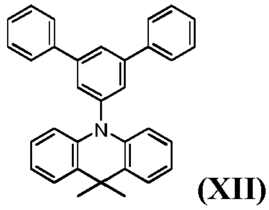 (XII) 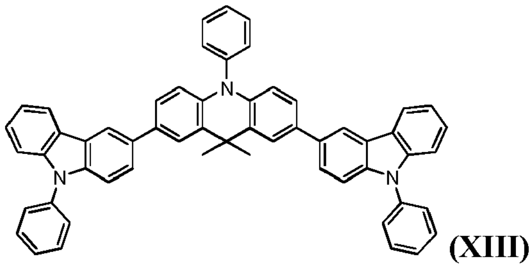 (XIII)

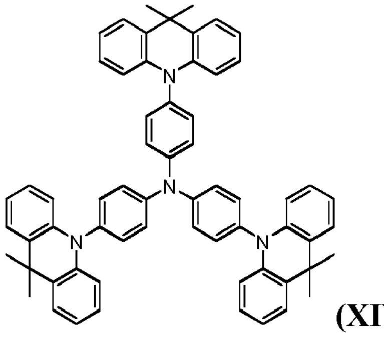 (XIV) 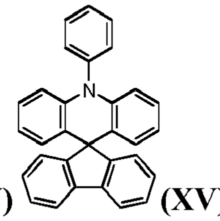 (XV)

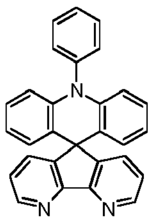 (XVI)

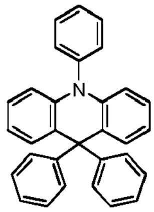 (XVII)

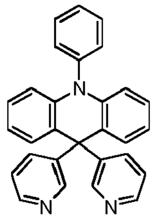 (XVIII)

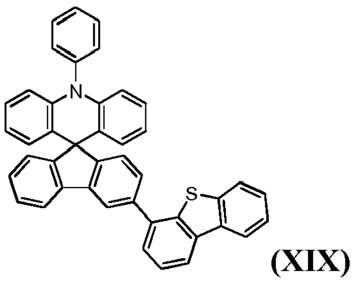 (XIX)

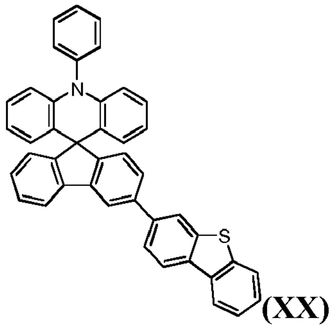 (XX)

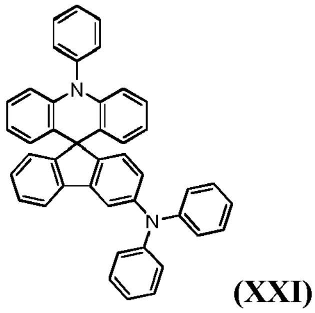 (XXI)

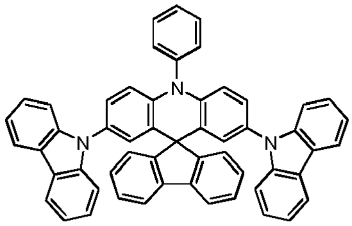 (XXII)

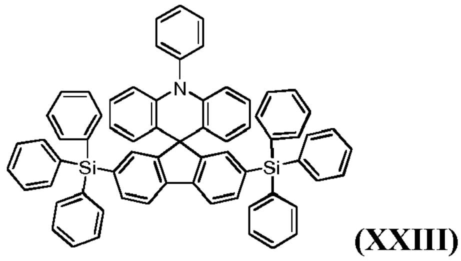 (XXIII)

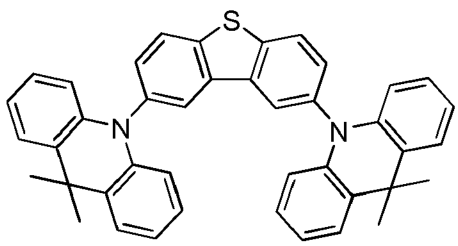 (XXIV) Binder 1

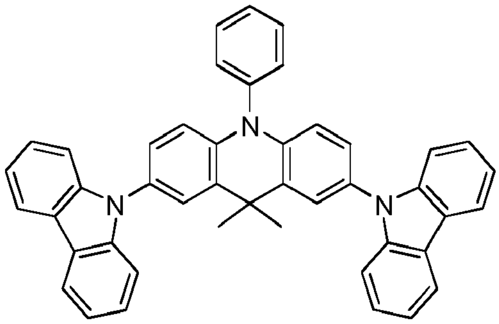 (XXV) Binder 2

The compound bearing at least one optionally substituted 9-$R_1$-9-$R_2$-9,10-dihydroacridine moiety in accordance with the invention is advantageously amorphous. It exhibits advantageously a glass transition temperature of at least 80°C, preferably of at least 100°C and even more preferably of at least 120°C.

It has been advantageous, in certain circumstances, that the compound bearing at least one optionally substituted 9-$R_1$-9-$R_2$-9,10-dihydroacridine moiety contained in the compositions of the present invention has a HOMO level

of less than -5.0 eV, preferably less than -5.2 eV and most preferably a HOMO level of less than -5.5 eV; besides, it has a LUMO level of more than -3.5 eV, preferably more than -3.3 eV and still more preferably more than -3.0 eV.

The composition in accordance with the invention comprises at least one crystalline organic semiconductor. By crystalline, is meant a compound that spontaneously self-organizes to give material which reveals a melting point that can be measured by any technique known by a person having ordinary skill in the art. For example, the presence of a melting point and its value can be determined by Differential Scanning Calorimetry. The crystalline organic semiconductor is chosen such that it exhibits a high tendency to crystallize when solution coating methods are used.

The crystalline semiconductor is preferably a small molecule which has a molecular weight of 1600 Daltons or less, preferably 1200 Daltons or less, more preferably 1000 Daltons or less, even more preferably 800 Daltons or less.

Preferred crystalline organic semiconducting materials which can be used in the present invention have a field effect mobility of at least 0.01 $cm^2/Vs$, preferably of at least 0.1 $cm^2/Vs$, more preferably of at least 1$cm^2/Vs$. The mobility referred to here is preferably determined in the saturation mode using a field effect transistor. In this technique, for each fixed gate voltage $V_{GS}$ the drain-source voltage $V_{DS}$ is increased until the current $I_o$ saturates. Next, the square root of this saturated current is plotted against the gate voltage and the slope $m_{sat}$ is measured. Then the mobility is

$$\mu = m_{sat}^2\ 2L/WC_i \qquad \text{(Equation 1)}$$

where L and W are the length and width of the channel and $C_i$ is the gate insulator capacitance per unit area.

There is no limitation in the choice of the structure of the crystalline organic semiconductor that can be used in the present invention. The person skilled in the art can select the crystalline organic semiconductor based on his professional knowledge and based on some reviews on the subject. Crystalline organic semiconductors having suitable structures can be found in the review of Daoben Zhu et al. in Chemical Reviews, 2012, 112, 2208-2267 and more particularly in Table 2 of the said review.

Exemplary small molecule organic semiconductors are selected from compounds of formulae:

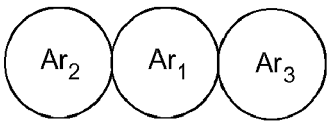
**(1)**

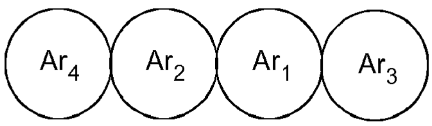
**(2)**

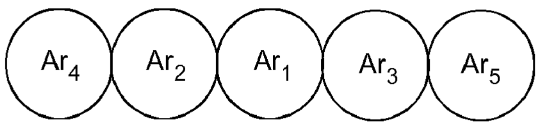
**(3)**

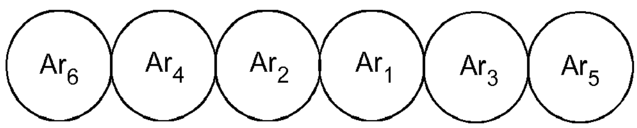
**(4)**

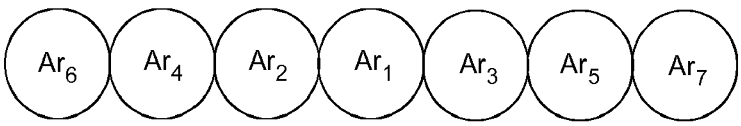
**(5)**

wherein $Ar_1$ to $Ar_7$ are the same or different at each occurrence and are each independently selected from the group

consisting of monocyclic aromatic rings and monocyclic heteroaryl aromatic rings, with at least one of $Ar_1$ to $Ar_7$ being substituted with at least one substituent Z which may be the same or different at each occurrence and is selected from the group consisting of unsubstituted or substituted straight, branched or cyclic alkyl groups having from 1 to 50 carbon atoms, alkoxy groups having from 1 to 50 carbon atoms, aryloxy groups having from 6 to 40 carbon atoms, alkylaryloxy groups having from 7 to 40 carbon atoms, alkoxycarbonyl groups having from 2 to 40 carbon atoms, aryloxycarbonyl groups having from 7 to 40 carbon atoms, amino groups that may be unsubstituted or substituted with one or two alkyl groups having from 1 to 20 carbon atoms, each of which may be the same or different, amido groups, silyl groups that may be unsubstituted or substituted with one, two or three alkyl groups having from 1 to 20 carbon atoms, silylethinyl groups that may be unsubstituted or substituted with one, two or three alkyl groups having from 1 to 20 carbon atoms, alkenyl groups having from 2 to 20 carbon atoms, the carbamoyl group, the haloformyl group, the formyl group, the cyano group, the isocyano group, the isocyanate group, the thiocyanate group, the thioisocyanate group, OH, nitro, cyano, haloalkyl groups having 1 to 20 carbon atoms and wherein $Ar_1$, $Ar_2$ and $Ar_3$ may each optionally be fused to one or more further monocyclic aromatic or heteroaromatic rings.

In accordance with a preferred embodiment at least one of $Ar_1$ to $Ar_7$ comprises a 5 to 7 membered heteroaryl group containing from 1 to 3 sulfur atoms, oxygen atoms, selenium atoms and/or nitrogen atoms.

In a still further embodiment $Ar_1$ to $Ar_7$ are independently selected from phenyl and thiophene and at least one of $Ar_1$ to $Ar_7$ is thiophene.

A first group of small molecule organic semiconductors in accordance with the above general formulae which can be used in the compositions of the present invention are oligo- and polyacenes.

Acenes or polyacenes are a class of organic compounds and parties cyclic aromatic hydrocarbons made up of linearly fused benzene rings, i.e. having a skeleton of general formula

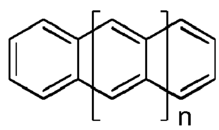

which may be substituted with substituents Z as defined above in any position. In preferred compounds of this group n is an integer in the range of from 1 to 4.

Pentacene compounds for which n is 3 and corresponding to formula (3) have been used in a number of applications for the manufacture of organic electronic devices. Exemplary representatives of suitable pentacene compounds are represented by formulae below:

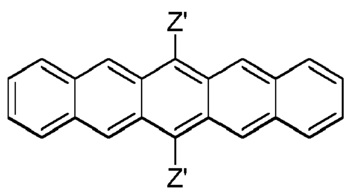

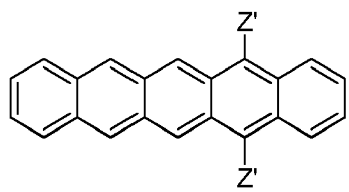

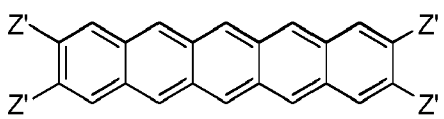

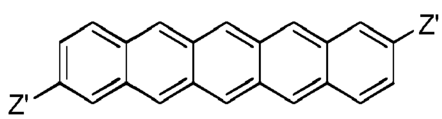

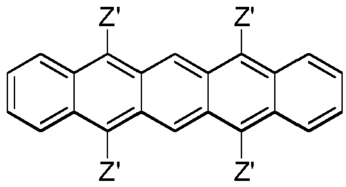

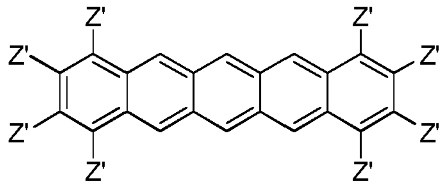

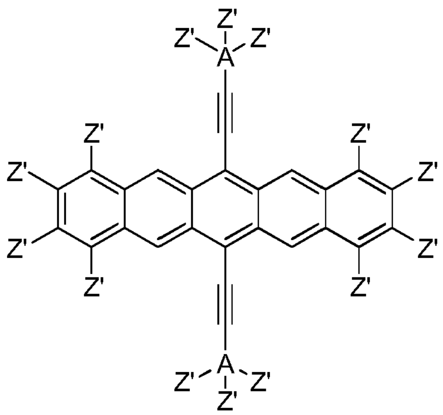

**(A)**

in which Z', which may be the same or different at each occurrence, is hydrogen or has a meaning as defined above for Z, with the proviso that at least one substituent Z' is different from hydrogen, and wherein A is carbon, silicon or germanium, preferably silicon or germanium. The substituents Z' at the atom A in this case are preferably alkyl groups or alkoxy groups having from 1 to 20, preferably from 1 to 12 and even more preferably 1 to 8 carbon atoms.

Still another group of compounds corresponding to formula (3) is represented by formula

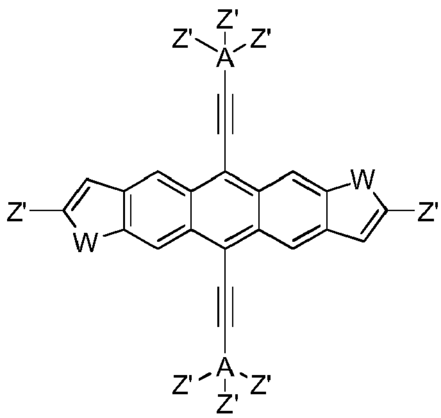

**(B)**

wherein again Z' and A are as defined above and may be the same or different at each occurrence and wherein W is selected from the group consisting of S, NH, NZ' or Se, preferably from S or Se. The substituents Z' at the atom A in this case are preferably alkyl groups or alkoxy groups having from 1 to 20, more preferably from 1 to 12 and even more preferably from 1 to 8 carbon atoms and the substituent Z' in NZ' is an alkyl group having from 1 to 12, more preferably from 1 to 8 carbon atoms.

Another group of compounds of general formula (2) preferred as organic semiconductors in the present invention are compounds of general formula

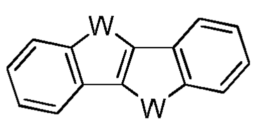

**(C)**

wherein W is as defined above and which may bear substituents Z' as defined above at any of the carbon atoms of the ring system.

Another group of compounds of general formula (4) preferred as organic semiconductors in the present invention are compounds of general formula

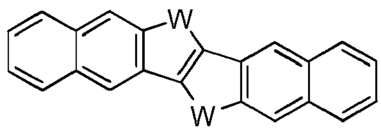

**(D)**

wherein W is as defined above and which may bear substituents Z' as defined above at any of the carbon atoms of the ring system.

Another group of compounds of general formula (5) preferred as organic semiconductors in the present invention are compounds of general formula

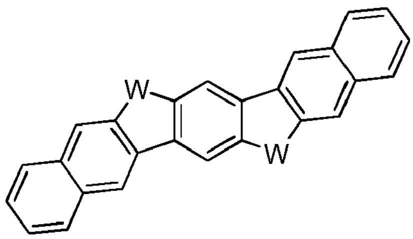

**(E)**

wherein W is as defined above and which may bear substituents Z' as defined above at any of the carbon atoms of the ring system.

Still another group of preferred organic semiconductors in the compositions of the present invention and corresponding to formula (3) are furan or thiophene V-shaped organic semiconducting materials of general formula

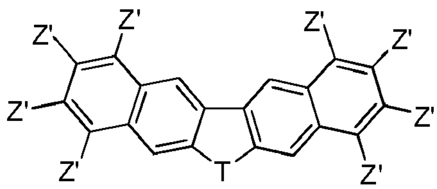

wherein T is an oxygen or a sulfur atom and Z', which may be the same or different at each occurence, may have the meaning as defined above.

Representative examples are

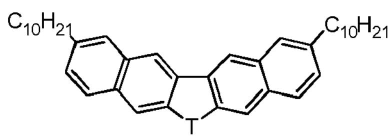

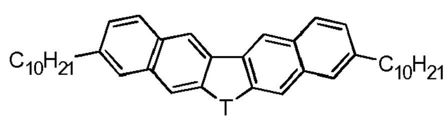

wherein T is preferably sulfur.

Compounds of this structure as well as their synthesis have been described in Adv. Mater. 2013, 25, 6392-6397 and Chem. Comm. 2014, 50, 5342-5344 to which reference is made for further details.

Still another group of preferred organic semiconductors in the compositions of the present invention and corresponding to formula (1) is V-shaped organic semiconducting materials of general formula

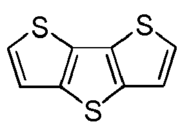

which may bear substituents Z' as defined above at any of the carbon atoms of the ring system.

Representative examples are

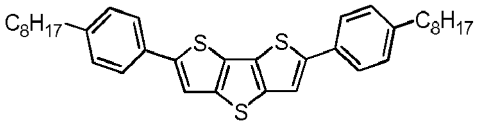
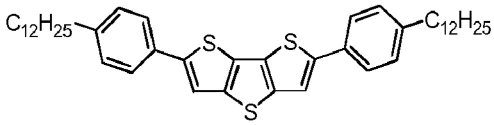

Compounds of this structure as well as their synthesis have been described in Chem. Comm. 2013, 49, 6483-6485 to which reference is made for further details.

Particularly preferred examples for compounds of formula **(A)** are the compounds of formulae below which are generally known under the names given next to the formula

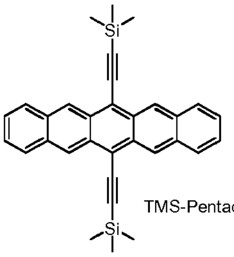

TMS-Pentacene

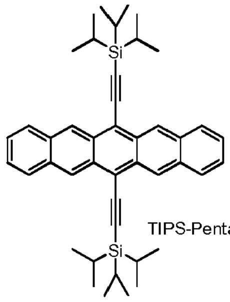

TIPS-Pentacene

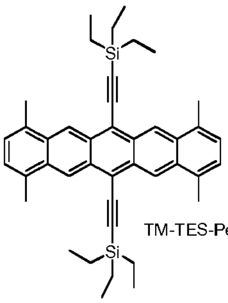

TM-TES-Pentacene

**(OS1)**

A preferred organic semiconductor corresponding to a general formula (B) is represented by formula

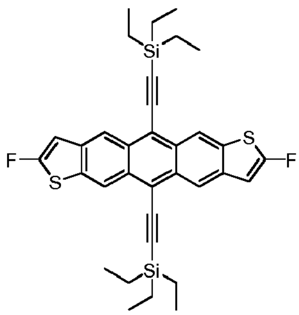

diF-TES-ADT

Particularly preferred representatives of general formula (C) are benzothieno benzothiophene derivatives represented by general formula below

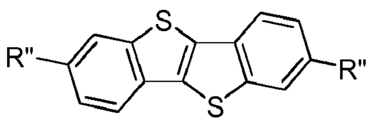

wherein R", which may be the same or different, represents an alkyl group having 1 to 30, preferably from 1 to 20 and most preferably from 1 to 12 carbon atoms. A particularly preferred compound of this group is known as C8-BTBT in which both substituents R" are n-$C_8H_{17}$ (n-octyl) groups.

Particularly preferred representative of general formula **(D)** is Dinaphtothienothiophene derivative represented by general formula below

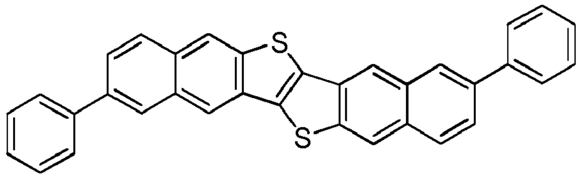

Particularly preferred representatives of general formula (E) are derivatives represented by general formula below

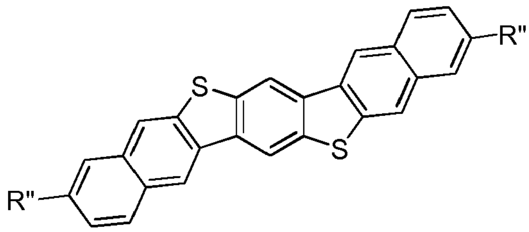

wherein R", which may be the same or different, represents an alkyl group having 1 to 30, preferably from 1 to 20 and most preferably from 1 to 12 carbon atoms. A particularly preferred compound of this group is known as C10-DNBDT in which both substituents R" are n-$C_{10}H_{21}$ groups.

In the composition according to the invention, the weight ratio of crystalline organic semiconductor to the compound bearing at least one optionally substituted 9-$R_1$-9-$R_2$-9,10-dihydroacridine moiety is comprised from 5/95 to 95/5, preferably from 25/75 to 75/25, more preferably from 34/66 to 66/34.

The composition according to the invention may be available in the form of an ink, i.e. it further comprises at least one organic solvent, which form makes it easily deposited onto a substrate.

In such case the combined content of the compound bearing at least one optionally substituted 9-$R_1$-9-$R_2$-9,10-dihydroacridine moiety and of the crystalline organic semiconductor versus the total weight of the composition (i.e. including, inter alia, the organic solvent) is of at least 0.5 wt %, preferably of at least 1 wt % and more preferably of at least 1.5 wt %; besides, the combined content of the compound bearing at least one optionally substituted 9-$R_1$-9-$R_2$-9,10-dihydroacridine moiety and of the crystalline organic semiconductor versus the total weight of the composition (i.e. including, inter alia, the organic solvent) is of at most 10 wt %, preferably of at most 5 wt % and more preferably of at most 3 wt %, with regard to the total weigh of the composition.

In particular embodiments, the composition is coated onto a substrate by vacuum deposition. Then, it is advantageously free of solvent. Besides, when the composition according to the invention is available in the form of an ink, the solvent comprised in the ink is advantageously removed from the composition after the ink is deposited on the substrate, thereby obtaining advantageously a composition essentially free or even completely free of solvent.

Thus, in the invented composition, an organic solvent may be present or not.

In any case, the weight content of the compound bearing at least one optionally substituted 9-$R_1$-9-$R_2$-9,10-dihydroacridine moiety is generally of at least 5 wt. % with regard to the total weight of the composition diminished by the weight of the organic solvent, whatever present or not. It is preferably of at least 25 wt. %, more preferably of at least 35 wt. %, even more preferably of at least 50 wt. % with regard to the total weight of the composition diminished by the weight of the organic solvent. Besides, the weight content of the compound bearing at least one optionally substituted 9-$R_1$-9-$R_2$-9,10-dihydroacridine moiety is generally of at most 95 wt. % with regard to the total weight of the composition diminished by the weight of the organic solvent; it is preferably of at most 85 wt. %, more preferably of at most 75 wt. %, even more preferably of at most 65 wt. % with regard to the total weight of the composition diminished by the weight of the organic solvent.

The viscosity of the solvents preferably is in the range of from 0.2 to 50 mPa.s, preferably in the range of from 1 to 20 mPa.s, measured at 25°C.

The Hansen solubility parameters of the solvent used, expressed in $MPa^{1/2}$, are preferably within the following ranges:

Hd: 15 to 25, preferably 17 to 23
Hp: 0 to 20, preferably 0 to 15
Hh: 0 to 25, preferably 0 to 20
wherein Hd, Hp and Hh respectively represent the dispersive, the polar and the hydrogen bonding solubility parameters.

The solvent surface tension in mN/m (at 20°C) is preferably in the range of from 10 to 70, more preferably in the range of from 20 to 50 and most preferably in the range of from 26 to 38.

Examples of suitable and preferred organic solvents include, without being limited to, dichloromethane, trichloromethane, monochlorobenzene, o-dichlorobenzene, the respective bromobenzenes, tetrahydrofuran, anisole, morpholine, toluene, o-xylene, m-xylene, p-xylene, the isomeric trimethylbenzenes, in particular 1,3,5 trimethylbenzene (also known as mesitylene), 1,4-dioxane, acetone, 1,1,2,2-tetrachloroethane, ethyl acetate, n-butyl acetate, dimethylformamide, dimethylacetamide, dimethylsulfoxide, tetralin (tetrahydronaphthalene), halogenated naphthalenes, such as 1-bromo naphthalene, decalin, indane and/or mixtures thereof.

Especially preferred solvents for use in the compositions according to the present invention are anisole, the isomeric xylenes, toluene, mesitylene, tetralin, chlorobenzene, bromobenzene, o-dichlorobenzene and 1-bromonaphthalin and/or mixtures thereof.

Even more preferred solvents are anisole and tetralin.

The preferred solvents have a boiling point in the range of from 80 to 350, preferably of from 100 to 300 and even more preferably of from 130 to 230°C.

The composition in accordance with the present invention can additionally comprise one or more further components like e.g. surface-active compounds, lubricating agents, wetting agents, dispersing agents, hydrophobic agents, adhesive agents, flow improvers, defoaming agents, deaerators, diluents (reactive or non-reactive), auxiliaries, colorants, dyes, pigments or nanoparticles.

It is also the object of the present invention to disclose the use of the composition in accordance with the present invention for the manufacture of a semiconducting layer.

The semiconducting layer obtained through the use of the composition in accordance with the present invention is typically at most 1 μm thick, preferably at most 500 nm although greater thicknesses may be achieved if required. The semiconducting layer obtained is typically at least 10 nm thick, preferably at least 50 nm.

The present invention also relates to a process for the manufacture of an organic semiconducting layer comprising applying the composition as above described to form a layer onto a substrate.

Preferably, in the invented process, the composition additionally comprises at least one organic solvent and the process further comprises evaporating the solvent from the layer.

Indeed to form a layer onto a substrate, especially a thin, layer, liquid coating of organic semiconductor composition is generally preferred over vacuum deposition which is possible anyway. The composition in accordance with the present invention enables the use of numbers of liquid coating techniques.

Just by way of example dip coating, spin coating, slot die coating, inkjet printing, letter-press printing, screen printing, doctor blade coating, roller printing, reverse roller-printing, offset lithography printing, flexographic printing, flexographic coating, spray coating, brush coating or pad printing may be mentioned here.

The inkjet fluid (i.e. the mixture of semiconducting compounds, binder and solvent) preferably has a viscosity at 20°C of 1-100 mPa.s, more preferably of 1-50 mPa.s and most preferably 1-30 mPa.s.

A substrate used for preparing the organic semiconducting layer may include any underlying device layer, electrode or separate substrate such as e.g. silicon wafer, glass or polymer substrate.

The present invention furthermore relates to an organic electronic device comprising an organic semiconducting layer in accordance with the invention. The electronic device generally comprises a gate electrode, a source electrode and a drain electrode, said device further comprises an organic semiconducting layer between the source and drain electrode, which organic semiconducting layer is obtained using the composition in accordance with the present invention.

Preferred organic electronic devices are organic field effect transistors.

The present invention finally relates to an electronic device comprising an organic field effect transistor comprising a semiconducting layer obtained using the composition in accordance with the invention.

The said electronic device is generally a display, more preferably an active matrix display, even more preferably an active matrix OLED display.

The following examples provide further information on the preferred embodiments of the present invention.

## Examples

Organic Thin Film Transistors (OTFTs) were fabricated in top gate and bottom contact configuration using glass based substrates as detailed hereinafter.

1" square glass substrates (ex: Corning XG) were cleaned using sonication bathes for 5 minutes in Deconex (3% in water) followed by rinsing in ultrapure water and dried using compressed air. A planarization layer was first spin coated on top of the cleaned substrates in order to create a 30 nm film after photocrosslinking. Au (30 nm) bottom contact source/drain (S/D) electrodes were deposited on top of the planarization layer by thermal evaporation through a shadow mask. The 16 transistors S/D consisted of electrodes with channel length of 50μm and channel width of 0.5mm. The substrates then underwent UV/$O_3$ treatment (model 42-220, from Jelight Company, Inc.), treatment time 5min. Prior to spin coating of the OSC solution, a 10mM solution of 4-fluorobenzenethiol in 2-propanol was applied to the surface of the electrodes for 1 minute followed by spin coating and rinsing by fresh 2-propanol, followed by drying on a hotplate at 100 °C. The organic semiconductor (OSC) formulation was spin coated onto the SD electrodes using a Laurell spinner set at 1500 rpm followed by baking on a hotplate for 60 seconds at 100°C. Hyflon® AD SF (9.2% w/w) solution commercialized by Solvay Specialty Polymers was spin coated at 3000 rpm and the samples were baked on a hotplate for 60s at 100°C. Gate electrodes were defined by evaporation of Aluminum (60nm) through a shadow mask in a thermal evaporator system.

## OTFT characterization

OTFTs were tested using a Cascade Microtech EP6 DC probe station in conjunction with an Agilent B1500A semiconductor parameter analyzer. The Agilent system calculated the linear mobility according to the equation shown below (Equation 2)

$$\mu_{Lin} = \frac{\partial I_{DS}}{\partial V_G}\frac{L}{WC_iV_{DS}} \qquad \text{(Equation 2)}$$

where L is the transistor length, W is the transistor width and $C_i$ is the dielectric capacitance per unit area. $V_{DS}$ was set at -4V unless otherwise stated. The mobility values reported are an average of the 5 highest points in accumulation for each transistor. The standard deviation of the mobility values is reported as a percentage of the mean.

**Comparative Example 1:** 1,4,8,11-tetramethyl-6,13-Triethylsilylethynylpentacene without binder; TG OTFT

The OTFT array fabricated and characterized as the comparative example 1 was fabricated and tested as described above. The formulation tested in the comparative example 1 included small molecule semiconductor however this formulation did not incorporate any binder.

1,4,8,1 1-tetramethyl-6,13-triethylsilylethynylpentacene represented by formula (**OS1**) was formulated in tetralin at 1.5% by weight total solids content. This was coated as an OSC layer in an OTFT device according to the method shown above for glass substrate.

The TFT performance of this formulation is shown below:

**μ Lin = 1.8±0.8 $cm^2$/Vs ; standard deviation as a % of the mean value of the mobility was 44.4 %.**

The OTFT array fabricated and characterized as the comparative example 2 was fabricated and tested as described above. The formulation tested in the comparative example 2 included a small molecule semiconductor and a triarylamine polymer as binder.

**Comparative Example 2:** 1,4,8,11-tetramethyl-6,13-Triethylsilylethynylpentacene with triarylamine polymer binder; TG OTFT

1,4,8,1 1-tetramethyl-6,13-triethylsilylethynylpentacene represented by formula (**OS1**) and Poly[bis(4-phenyl)(2,4,6-trimethylphenyl)amine] were formulated in tetralin in a ratio 50:50 at total solids content of 2% by weight. This was coated as an OSC layer in an OTFT device according to the method shown above for glass substrate.

The TFT performance of this formulation is shown below:

**μ Lin = 3.8±1.1 cm²/Vs; standard deviation as a % of the mean value of the mobility was 28.9 %.**

**Examples 1 to 2**

The OTFT arrays fabricated and characterized as the examples 1 to 2 were fabricated and tested as described above. The formulations tested in the examples 1 to 2 included small molecule semiconductor and an amorphous small-molecule as binder. In these examples the ratio of binder to the semiconductor is in parts by weight.

**Example 1:** 1,4,8,11-tetramethyl-6,13-Triethylsilylethynylpentacene with small-molecule bearing at least one optionally substituted 9-$R_1$-9-$R_2$-9,10-dihydroacridine moiety as the binder; TG OTFT 2,8-bis(9,9-dimethylacridin-10(9H)-yl)dibenzo[b,d]thiophene **(Binder 1),** was formulated with 1,4,8,1 1-tetramethyl-6,13-triethylsilylethynyl pentacene represented by formula (**OS1**) in a ratio 60:40 at a total solids content of 1.5% by weight in tetralin and coated as an OSC layer in an OTFT device according to the method shown above for glass substrate devices.

The TFT performance of this formulation is shown below:

**μ Lin = 5.3±0.5 cm²/Vs; standard deviation as a % of the mean value of the mobility was 9.4 %.**

**Example 2:** 1,4,8,11 -tetramethyl-6,13-Triethylsilylethynylpentacene with small-molecule bearing at least one optionally substituted 9-$R_1$-9-$R_2$-9,10-dihydroacridine moiety as the binder; TG OTFT 2,7-di(9H-carbazol-9-yl)-9,9-dimethyl-10-phenyl-9,10-dihydroacridine **(Binder 2),** was formulated with 1,4,8,11-tetramethyl-6,13-Triethylsilylethynylpentacene represented by formula (**OS1**) in a ratio 60:40 at a total solids content of 1.5% by weight in tetralin and coated as an OSC layer in an OTFT device according to the method shown above for glass substrate devices.

The TFT performance of this formulation is shown below:

**μ Lin = 4.8±0.4 cm²/Vs; standard deviation as a % of the mean value of the mobility was 8.5 %.**

The previous examples show that the composition in accordance with the present invention, comprising an organic semiconductor and a small molecule bearing at least one optionally substituted 9-$R_1$-9-$R_2$-9,10-dihydroacridine moiety as the binder yielded OTFTs with improved performance compared to OTFTs obtained using compositions in accordance with the prior art. More particularly, measured linear mobility values were high, the standard deviation of the mobility values was low and the bias stress stability was improved.

**Claims**

1. Composition comprising at least one crystalline organic semiconductor and at least one compound bearing at least one optionally substituted 9,9-disubstituted-9,10-dihydroacridine moiety, said compound corresponding to formula (a)

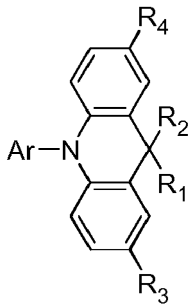

**Formula (a)**

and said compound being free of any spirobifluorene moiety corresponding to formula (b)

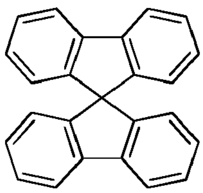

**Formula (b)**

wherein :

$R_1$ and $R_2$, which may be the same or different, represent a $C_1$-$C_{50}$ hydrocarbyl or heterohydrocarbyl group, optionally forming together an optionally substituted cyclic moiety,
$R_3$ and $R_4$, which may be the same or different, represent H or a $C_1$-$C_{24}$ hydrocarbyl or heterohydrocarbyl group, and
Ar is an optionally substituted aryl or heteroaryl group.

**2.** Composition according to claim 1 wherein the compound bearing at least one optionally substituted 9,9-disubstituted-9,10-dihydroacridine moiety has a molecular weight of 1600 Daltons or less.

**3.** Composition according to claim 1 or 2 wherein the crystalline semiconductor has a field effect mobility of at least 0.01 $cm^2/Vs$.

**4.** Composition according to any one of the preceding claims wherein the weight ratio of crystalline organic semiconductor to compound bearing at least one optionally substituted 9,9-disubstituted-9,10-dihydroacridine moiety is comprised from 5/95 to 95/5.

**5.** Composition according to any one of the preceding claims which is essentially free of solvent.

**6.** Composition according to any one of the preceding claims but 5 additionally comprising at least one organic solvent.

**7.** Use of the composition according to any one of claims 1 to 6 for the manufacture of a semiconducting layer.

**8.** Process for the manufacture of an organic semiconducting layer comprising applying the composition according to any one of claims 1 to 6 to form a layer onto a substrate.

**9.** Process according to claim 8, wherein the composition is the composition according to claim 6 and the process further comprises evaporating the solvent from the layer.

**10.** Device comprising the composition according to any one of claims 1 to 5 or the organic semiconducting layer manufactured by the process according to claim 8 or 9.

**11.** Device according to claim 10, which is or comprises a field effect transistor.

**12.** Device according to claim 11, which is a field effect transistor.

**13.** Display comprising the device according to claim 12.

Europäisches Patentamt
European Patent Office
Office européen des brevets

# EUROPEAN SEARCH REPORT

Application Number
EP 16 17 4445

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| A | BJÖRN LÜSSEM ET AL: "Organic Junction Field-Effect Transistor", ADVANCED FUNCTIONAL MATERIALS, WILEY - V C H VERLAG GMBH & CO. KGAA, DE, vol. 24, no. 7, 19 February 2014 (2014-02-19), pages 1011-1016, XP001588675, ISSN: 1616-301X, DOI: 10.1002/ADFM.201301417 [retrieved on 2013-10-24] * the whole document * ----- | 1-13 | INV. H01L51/00 H01L51/05 |
| A,D | LI FENGHONG ET AL: "Acridine orange base as a dopant for n doping of C60 thin films", JOURNAL OF APPLIED PHYSICS, AMERICAN INSTITUTE OF PHYSICS, US, vol. 100, no. 2, 31 July 2006 (2006-07-31), pages 23716-023716, XP012089470, ISSN: 0021-8979, DOI: 10.1063/1.2219374 * the whole document * ----- | 1-13 | |
| | | | TECHNICAL FIELDS SEARCHED (IPC) |
| A | WO 2012/033075 A1 (NIPPON KAYAKU KK [JP]; SADAMITSU YUICHI [JP]) 15 March 2012 (2012-03-15) * the whole document * ----- | 1-13 | H01L |
| A | DE 10 2009 005290 A1 (MERCK PATENT GMBH [DE]) 22 July 2010 (2010-07-22) * the whole document * ----- | 1-13 | |
| A | DE 10 2010 009903 A1 (MERCK PATENT GMBH [DE]) 8 September 2011 (2011-09-08) * the whole document * ----- | 1-13 | |

The present search report has been drawn up for all claims

1

| Place of search | Date of completion of the search | Examiner |
|---|---|---|
| The Hague | 28 November 2016 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 16 17 4445

This annex lists the patent family members relating to the patent documents cited in the above-mentioned European search report. The members are as contained in the European Patent Office EDP file on
The European Patent Office is in no way liable for these particulars which are merely given for the purpose of information.

28-11-2016

| Patent document cited in search report | Publication date | Patent family member(s) | Publication date |
|---|---|---|---|
| WO 2012033075 A1 | 15-03-2012 | CN 102770979 A | 07-11-2012 |
| | | JP 5913108 B2 | 27-04-2016 |
| | | KR 20120116971 A | 23-10-2012 |
| | | TW 201221519 A | 01-06-2012 |
| | | WO 2012033075 A1 | 15-03-2012 |
| DE 102009005290 A1 | 22-07-2010 | CN 102272966 A | 07-12-2011 |
| | | DE 102009005290 A1 | 22-07-2010 |
| | | DE 112009003900 A5 | 31-05-2012 |
| | | JP 5730784 B2 | 10-06-2015 |
| | | JP 2012515732 A | 12-07-2012 |
| | | KR 20110124243 A | 16-11-2011 |
| | | TW 201038535 A | 01-11-2010 |
| | | US 2011266533 A1 | 03-11-2011 |
| | | WO 2010083871 A1 | 29-07-2010 |
| DE 102010009903 A1 | 08-09-2011 | CN 102782894 A | 14-11-2012 |
| | | DE 102010009903 A1 | 08-09-2011 |
| | | DE 112011100731 A5 | 03-01-2013 |
| | | JP 5937018 B2 | 22-06-2016 |
| | | JP 2013521238 A | 10-06-2013 |
| | | KR 20110099643 A | 08-09-2011 |
| | | TW 201141847 A | 01-12-2011 |
| | | US 2012319052 A1 | 20-12-2012 |
| | | WO 2011107186 A2 | 09-09-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 102010061978
- US 2009165848 A


### Non-patent literature cited in the description


- *J. Appl. Phys.,* 2006, vol. 100, 023716
- **DAOBEN ZHU et al.** *Chemical Reviews,* 2012, vol. 112, 2208-2267
- *Adv. Mater.,* 2013, vol. 25, 6392-6397
- *Chem. Comm.,* 2014, vol. 50, 5342-5344
- *Chem. Comm.,* 2013, vol. 49, 6483-6485